Europäisches Patentamt

European Patent Office

Office européen des brevets

(11) Publication number: **0 206 619 B1**

# EUROPEAN PATENT SPECIFICATION

(45) Date of publication of patent specification: **20.01.93** (51) Int. Cl.⁵: **H05K 3/34**, H01R 9/07, H05K 1/02

(21) Application number: **86304393.1**

(22) Date of filing: **09.06.86**

(54) **Self-soldering, flexible circuit connector.**

(30) Priority: **20.06.85 US 746796**

(43) Date of publication of application:
**30.12.86 Bulletin 86/52**

(45) Publication of the grant of the patent:
**20.01.93 Bulletin 93/03**

(84) Designated Contracting States:
**AT BE CH DE FR GB IT LI NL SE**

(56) References cited:
**EP-A- 0 006 039**
**FR-A- 2 438 925**
**GB-A- 2 134 026**

**IBM TECHNICAL DISCLOSURE BULLETIN, vol.
9, no. 11, April 1967, page 1688, New York,
US; T.L. PALFI et al.: "Selective electrical
heater system for module removal".**

**PATENT ABSTRACTS OF JAPAN, vol. 9, no.
10 (E-290) (1733), 17th January 1985; & JP - A
- 56 161 056 (FUJI DENKI SOUGOU KEN-
KYUSHO K.K.)**

(73) Proprietor: **METCAL INC.**
**3704 Haven Court**
**Menlo Park California 94025(US)**

(72) Inventor: **Kent, Harold B.**
**1337 Cordilleras Avenue**
**San Carlos California 94070(US)**

(74) Representative: **Hayward, Denis Edward Peter
et al**
**Lloyd Wise, Tregear & Co. Norman House
105-109 Strand
London WC2R 0AE(GB)**

## Description

The present invention relates to flexible circuits and more particularly to flexible circuits and flexible circuit boards having an integral heater.

Flexible circuits are being employed increasingly to improve the architecture of modern high density electronic circuitry and in the form of ribbon conductors to interconnect parts movable with respect to one another. As complexity and thus density of packaging of circuits increases, the problems of miniaturising interconnection devices without sacrificing reliability of the interconnection becomes increasingly difficult. As printed circuit boards and electrical connectors become smaller, the ability to securely grasp a connecting board or base member and to hold it in the face of vibration, expansion and contraction in the presence of heat and cold, creep and the like becomes a mechanical problem requiring in many instances rather elaborate, albeit quite small, mechanical devices which at best only mitigate the problems. Even so the connectors remain a size-bulk problem and securing them to delicate printed circuit boards is still another and even greater problem.

IBM Technical Disclosure Bulletin Vol. 9, No. 11, April 1967, page 1668 describes a substrate serving as a mounting board for electronic chip carrier modules which have pins that arc soldered into receptacles or buckets in the substrate. To remelt the solder to facilitate removal of individual chip carrier modules, an orthogonal matrix of heater wires is embedded in the substrate, with heater terminals arranged around the edges of the substrate, and a power supply is connected to the terminals of selected heater wires that cross over in the region of the solder buckets of any individual module that is to be removed.

An object of the present invention is to achieve a connection technology, capable of reuse if desired, that combines a high density capability, equivalent to that of an elastomeric connector, with the reliability of a solder joint.

According to the present invention, there is provided an electrical circuit assembly for connection to other circuits, comprising one or more electrical conductors embedded in and covered by a body of insulating material having two large opposed surfaces, said conductor or each conductor having a connection region where it is exposed at one of said opposed surfaces, characterised in that the body of insulating material containing the embedded conductor or conductors is flexible and a self-regulating electrical resistance heater to apply heat for making electrical connection, especially soldered connection, and adapted to be energized from a source of substantially constant a.c. current is disposed along the other of said opposed surfaces at the region opposite that where said conductor or conductors are exposed.

The invention further provides a method of making multiple electrical circuit connections, such as in the connecting together of electrical circuit boards, wherein a first array of exposed portions of otherwise insulated electrical conductors embedded in a circuit board are soldered to a co-operating second array of exposed portions of conductors of another circuit assembly by the application of heat to melt the solder, characterised in that said first array of conductor portions is exposed at one surface of a circuit board made of a flexible insulating material and, after the two arrays of exposed conductor portions have been brought together in assembled alignment and solder has been supplied to their contact surfaces, the heat to melt the solder is generated by a self-regulating electrical resistance heater energised by a substantially constant a.c. current which heater is applied to the other surface of the flexible circuit board opposite to said first array of exposed conductor portions.

In the preferred arrangement, a self-regulating temperature controlled heater of the order of as little as .030 inch (.76mm) thick is applied to the flexible circuit over an area where solder connections between the flexible circuit and another circuit or component are to be made. The insulation over the conductors is removed on the side away from the heater and the exposed conductors are covered with solder or other conductive heat-activated material. Alternatively the exposed conductors are tinned and a reflowable solder pad on the board is employed, this combination being preferable in most high density uses.

The heater is preferably of a type operating in the manner disclosed in U.S. Patent No. 4,256,945. Such heaters employ a technique for temperature regulation based on a combination of alternating current skin effect, the Curie point of ferromagnetic material and a relatively constant current supply to cause the heater to maintain a constant temperature determined by the composition of the ferromagnetic material utilised. For the solder standardly used in electronic circuits the temperature of the heater typically could be approximately 265°C.

The underlying theory in all of these heaters is that since the power delivered to the heater is $P = I^2 R$ and if the current is held relatively constant, then the energy dissipated is a function only of the thermal resistance of the heater. The heater resistance above Curie temperature is less than that below as a result of the large reduction in skin effect which permits a large proportion of the current to spread out of the relatively high resistance ferromagnetic layer into a layer of lesser resistance or into a thicker layer thus reducing current density and accordingly resistance.

Flexible circuits with heaters as set forth herein are capable of use to connect pad and pin grid arrays to p.c. boards or the like and to connect, for instance, 166 conductors in a 8.4 inch (213mm) wide circuit having the conductors at .05 inch (1.27mm) centres to a p.c. board or substrate in a surface mount configuration.

The flexible circuit may be used to interconnect printed circuit boards, leaded and leadless chip carriers to printed circuit boards and printed circuit boards or the equivalent to multiple printed circuit boards. Further, the flexible circuit may be employed in a U-shaped configuration to contact exposed conductors on both sides of a daughter board and to contact conductors on a mother board all at the same time to provide a variety of selectable interconnections.

In the various embodiments of the invention, use may be made of the advantages of the reliability, precise temperature control and relatively low temperature of the heaters, the solid connections provided by the solder and the flexibility of the circuits. Zero and low insertion force connectors are vastly improved since the solder imparts a very positive holding force at every contact point.

Arrangements embodying the invention will now be described in more detail by way of example and with reference to the accompanying drawings, in which:-

Figure 1 is a top view of a flexible circuit according to the present invention;

Figure 1A is a top view of a variation of the arrangement of Figure 1;

Figure 2 is a side view of the circuit of Figure 1;

Figure 3 is a cross-sectional view of a heater incorporated in the circuit of Figure 1;

Figure 4 is a detailed view of the heater terminal contact structure;

Figure 5 is a pictorial view of a flexible circuit being soldered in place on a printed circuit board;

Figure 5A is a side view in elevation of the combination of Figure 5;

Figure 6 is a pictorial view of several uses of a flexible circuit according to the invention;

Figure 7 is a sectional view of a daughter board support incorporating the heater-flexible circuit arrangement of the present invention;

Figure 8 is a pictorial view of the device of Figure 7;

Figure 9 is a view in section of a preferred form of heater;

Figure 10 is a diagrammatic side view of an embodiment incorporating the heater of Figure 9;

Figure 11 is a partly sectional side view of a pressure fit circuit board connector employing the present invention;

Figure 12 is a perspective view of a flexible circuit of the present invention employed to connect a chip mounted on a leadless chip carrier to a printed circuit board;

Figure 13 is a top view of the flexible circuit of Figure 12;

Figure 14 is a view in elevation of part of the structure of Figure 12;

Figure 15 is a perspective view of flexible circuits employed to connect multiple daughter boards.

Figure 16 is a perspective view of a modification of the structure of Figure 12;

Figure 17 is a perspective view of another form of heater for use with the flexible circuits of the present invention;

Figure 18 is a perspective view of a structure according to the present invention employing a solder reflow pad;

Figure 19 is a sectional view of the structure of Figure 18.

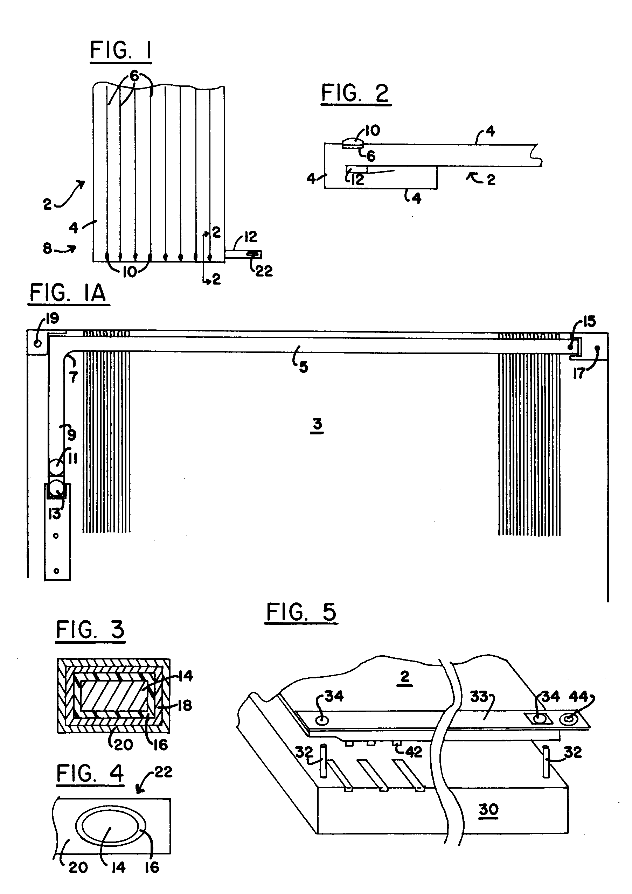

Referring now specifically to Figures 1 and 2 of the accompanying drawings, there are illustrated two views of a flexible circuit with an integral heater. The flexible circuit, generally designated by the reference numeral 2, has embedded in an insulating flexible body 4, a plurality of conductors 6. The conductors 6 are illustrated for purposes of description only as a series of parallel conductors; it being understood that the conductors can conform to any desired pattern so long as, in the region where connection to an external or internal circuit or connector is to be made, they are arrayed in conformance with the circuit array of that other circuit or connector. This region is generally designated by the reference numeral 8.

In the region 8, the insulation covering the conductors 6 is removed and solder 10 or other heat activated conductive material is applied to the bared conductors 6. A heater 12 lies across the region 8 of the flexible circuit, as viewed in Figure 2, being located on the opposite side of the circuit from the bared conductors 6. The insulation 4 in this embodiment is brought round to cover the heater and extends beyond the heater, where it is united to the main body of the flexible circuit. Thus the heater is sealed into the circuit 2, at the region of the exposed conductors and solder, for heating the solder to its melt temperature and above to such extent as may be desired.

Referring to Figure 1A, an alternative layout of the heater structure is illustrated. A heater 5 is again laid across an end region of a flexible circuit board 3 but instead of its end portion extending straight out of the edge of the flexible circuit as in Figure 1, it makes a 90° turn as at 7 and has a length 9 extending along a side edge of the circuit. Here current contact terminals 11 and 13 are provided; and in this embodiment a grommet 15 is passed through the opposite end of the heater remote from the terminals 11 and 13 to electrically connect the various layers together. Aligning holes 17 and 19 are provided in the corners of the board 3.

Referring to Figure 3, the heater 12 of Figure 1 is a self-regulating heater. A self-regulating heater of the type which may be employed herein includes a conductor 14 surrounded by a thin layer 16 [.002" (.05mm) for instance] of the insulation 4. Surrounding the layer 16 is a layer 18 of ferromagnetic material about 1 to 1.8 skin depths thick, itself surrounded by a layer of copper 20. In its physical realisation, the heater illustrated may be 0.030 inch (0.76mm) thick, about 0.180 inch (4.6mm) wide, 9 inches (229mm) long and delivers about 250 watts of power at a temperature of 265°C: about the temperature of a wave solder machine.

As disclosed in US-A-4,256,945, if the heater is connected across a source of constant alternating current, the heater autoregulates at or approaching the Curie temperature of the ferromagnetic layer which in this application is, as indicated above, approximately 265°C. Connection to the heater 12 is made at end location 22 of the heater (see Figure 4) where the copper-ferromagnetic outer layers are removed over an area to expose a region of the insulation 16 and a smaller region of the insulation is removed to expose the conductor 14. The copper-ferromagnetic layers 20-18 on the one hand and the return conductor 14 on the other hand are connected together electrically at the end of the heater remote from the region 22; that is, at the left end of the heater as viewed in Figure 1. This connection may be achieved simply by discontinuing the insulating layer 16 just short of the end of the heater remote from region 22 and compressing the end portion so that the conductors are all in contact; or the layers may be soldered together.

The heater 12 is illustrated in Figure 1 as extending outwardly from the flexible circuit 2 but may well be terminated at the edge of the circuit 2 with the region 22 lying outwardly of the outermost conductor 6; or the heater contact area may lie along the side of the flexible circuit as in Figure 1A.

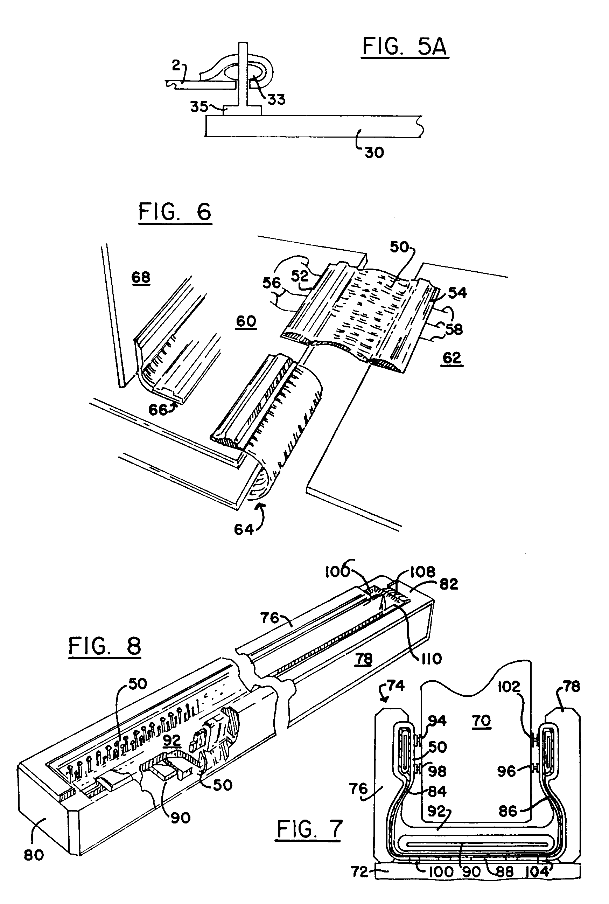

Referring now to Figures 5 and 5A of the accompanying drawings, there is illustrated, in pictorial view and side view, the connector region 8 of the flexible circuit 2 of Figure 1 in alignment with a printed circuit board 30 to which the circuit 2 is to be connected. To insure alignment of the connector 8 of the circuit 2 the connector 8 is provided with alignment holes 34 to mate with pins 32 on the printed circuit board 30.

To connect the conductors 42 of the flexible circuit 2 to the printed circuit board 30, the pins 32 are aligned with holes 34 and the two boards are pressed together while current is applied to the heater 33 through a hole 44 in the upper surface of the circuit as viewed in Figures 5 and 5A. One of the important advantages of the arrangement is that the connections may be readily broken and remade a number of times thus greatly facilitating repair and maintenance. A solder carrier pad 35, described in more detail below, may also be employed.

Another advantage of this type of connection is the ability to connect the flexible circuit to two or more distinct circuit boards. Reference is made now to Figure 6 of the accompanying drawings. A flexible circuit 50 is provided at its two ends with heater and bared conductor arrangements 52 and 54. These flexible circuit ends may be soldered lead for lead to leads 56 and 58, respectively, on printed circuit boards 60 and 62. In such an arrangement a separate connector is not required since it is standard practice for printed circuit boards to terminate in parallel conductors for insertion into connectors. In such a case, alignment can be obtained by having studs protruding from the printed circuit board for insertion into mating holes in the flexible circuit, by an alignment housing, or, in the case of a daughter board, by slots within the flexible circuit for cooperation with ridges on the daughter board. Since the flexible circuit is highly flexible, it may bend around the end of a daughter board, such as at 64, or bend to connect to another board at 90°, such as board 68, thus adding greatly to the architectural freedom of the physical layout of a piece of equipment.

Referring now to Figures 7 and 8 of the accompanying drawings, the flexible circuit 50 of Figure 6 may be employed in a still further environment. A printed circuit board 70 is to be connected to an interconnect board 72 via a zero insertion force connector 74 in the form of an elongated box open at the top and bottom. The body of the connector is composed of two side walls 76 and 78 and end walls 80 and 82. The walls are made preferably of a resilient material, such as METALOR (Registered Trade Mark) polymer. The flexible circuit 50 forms a "U" that has its legs 84 and 86 secured in the side walls 76 and 78 and has its base 88 extending across the open bottom of the connector 74. There may be three different heaters employed in this embodiment; two bonded to the upper ends of the legs of the "U" on the outer sides thereof. A third heater 90 of the type described in Figure 3 lies on top of the base portion 88 of the flexible circuit 50 and a resilient pad 92 is placed over the heater to hold it in position, to cushion the printed circuit board, and to provide mechanical compliance.

In this embodiment, the board 70 has independent circuits on both its faces and each such circuit is to be connected independently to one or more circuits which may reside on the other side of the board 70 or on the interconnect board 72. Connections between the two sides of the board are made by removal of the insulation from the two ends of the same conductor of the flexible circuit, while connection from one side or the other of the board 70 to the interconnect board 72 is made by having an exposed conductor with solder along the base 88 of the "U"-shaped flexible circuit which connects to the interconnect board through an aperture in the base of the flexible circuit. Thus, by simply selecting beforehand the areas of the conductors of the flexible circuit that are to be exposed, quite complex interconnection arrangements between multiple circuits are possible in addition to the primary printed circuit board-to-board connections.

In an example of various possible interconnections, the flexible circuit may interconnect a conductor 94 on the left side of the board 70 to conductor 96 on the right side of the board 70, this approach being particularly useful with metal core boards where through-holes cannot be used. Continuing, a conductor 98 on the left side of the board 70 may be connected to a conductor 100 on the interconnect board 72 and a conductor 102 on the right side of board 70 to a conductor 104 on the board 72, all as viewed in Figure 7. Power connection with the heaters may be made at the locations 106, 108 and 110 of Figure 8.

The scale of the drawings is not intended to be accurate; for example, the spacings between contacts on many of these types of contact structures is much closer than illustrated, the structures of Figures 1 and 7, for instance, having spacings of the order of only several mils (several quarters of a tenth of a millimetre) to a hundred mils (2.5mm). The conductors of the flexible structures can be as fine as those of the connectors or in some instances one conductor of a flexible circuit may bridge several conductors of a daughter board to assure contact, thereby reducing the required accuracy of the aligning structures. Alternatively, a contact of the flexible circuit may be made long enough to bridge two contacts of the board 70, for instance contacts 94 and 98 of Figure 7, or the contacts on the flexible circuit can be staggered as at 50 so that a larger contact area can be provided for each fineline trace. In a typical example, a 166 line 8.4 inch (213mm) wide flexible circuit has 0.05 inch (1.27mm) spacing between the centres of conductors. Thus a very low profile, highly vibration resistant connector is provided particularly as seen in Figure 5.

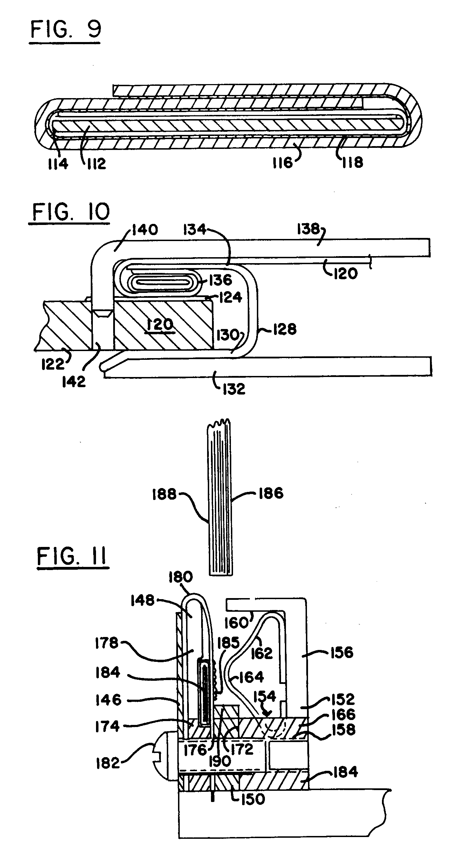

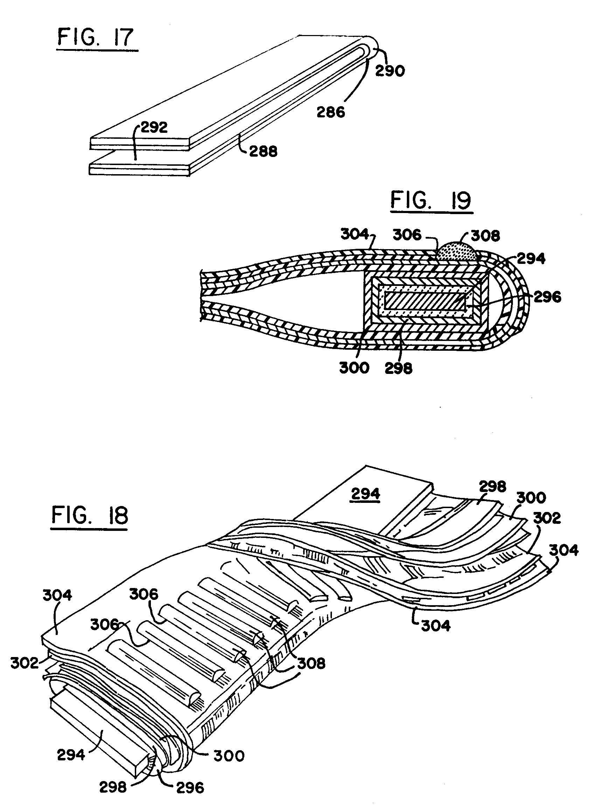

Referring now to Figure 9 of the accompanying drawings, there is illustrated a form of heater that may be employed as the heater 90 of Figure 7. (Also see Figure 18). The heater 90 illustrated in Figure 9 comprises a conductor 112, with a layer 114 of insulation (polyimide) surrounding and overlapped across the entire top of the conductor 112. The insulator is bonded on to the conductor with a suitable adhesive. The structure is enclosed by an outer layer 116 of copper having an inner lining 118 of ferromagnetic material. The copper layer 116 is also overlapped but does not require bonding since it will hold its bends.

The heater of Figure 9 may also be employed in the arrangement of Figure 10 which diagrammatically illustrates a different physical arrangement employing the heater and a flexible circuit. Flexible circuit 120 is to be joined to a printed circuit board 122 having contacts 124, only one of which is illustrated. The arrangement is similar to a large clothes peg or spring clip and employs a U-shaped spring 128 having a first leg 130 secured to a first finger-engageable member 132. A second leg 134 of the spring 128 has the flexible circuit 120 bonded to an upper surface thereof as viewed in Figure 10, the flexible circuit being folded over the end of leg 134 and extending under the leg. A heater 136 is laminated into the flexible circuit and lies under the leg 134 and this assembly is situated such as to be in contact with the printed circuit board 122. An L-shaped aligning pin 138 has its long leg secured to the top surface, as viewed in Figure 10, of the flexible circuit and its short leg 140 extending into an alignment hole 142 in the printed circuit board.

By squeezing the members 132 and 138 together, the leg 140 is raised and the structure may be applied to or, if already applied, withdrawn from the printed circuit board 122. Thus the mechanism that provides the application and removal tool also provides for alignment of the two members.

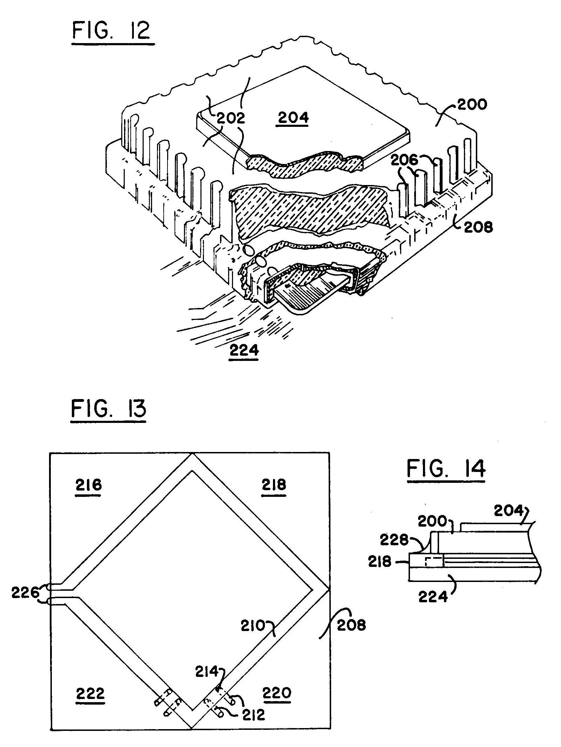

Referring now specifically to Figure 11 of the accompanying drawings, there is illustrated in vertical section still another connector for printed circuit boards. This connector is a force fit type providing wiping of the contact areas upon insertion and withdrawal of the board. The drawing illustrates only the single heater case; the connector can have coplanar connection heaters as well as heaters and circuits on both sides of the board. A connector housing is composed of four main parts, a flexible circuit clamp 146, a two-part flexible circuit containment member comprising containment plates 148 and 150 and a main connector shell 152. The shell 152 has an elongated base 154 having an upside down L-shaped member 156 extending upwardly from the right edge thereof, as viewed in Figure 11. The base extends to the left of the L-shaped member 156 to provide a surface 158 parallel to and spaced from the lower surface 160 of the horizontal top leg of the L-shaped member 156. A generally triangular spring 162 is positioned between surfaces 158 and 160 and has a generally rounded apex 164 directed toward the left in Figure 11 and located about halfway between surfaces 158 and 160. The spring 162 is retained between side walls 166, only one of which is illustrated in Figure 11.

The circuit containment plates 148 and 150 have the part 150 abutting against a left vertical surface 172 of the connector shell 152. The plate 148 has a lower region 174 having a vertical surface 176 coextensive with surface 172. Upper region 178 of member 148 defines a space between itself and the flexible circuit clamp 146 in which a flexible circuit 180 is clamped between the members 146 and 148. This flexible circuit 180 comes over the top of the containment plate 148 at about the level of the top leg of the L-shaped member 156, and then descends downward in open space to pass opposite the apex 164 of the spring 162, subsequently passing between the containment plates 148 and 150 and out of the connector. The structure is held together by bolts 182 at opposite ends of the base 154, the bolts passing in sequence through members 146, 148, 150 and into the base 154. The flexible circuit containment plate 148 is recessed both opposite the apex 164 of spring 162 and somewhat downwardly thereof to receive heater 184 which may be separate from and bonded to or laminated in the flexible circuit 180. The flexible circuit 180 has the insulation removed from its conductors in region 185 opposite the apex of the spring 162 and has solder applied thereto.

In use, a daughter board 186 is inserted by pressing it downwardly between the spring 162 and the flexible circuit 180. The spring causes the board contact area 188 to be forced against region 185 of the flexible circuit as it is inserted thereby wiping the contact areas. The board comes to rest on the top surface 190 of the containment plate 150, which extends between side walls 166 and serves as an alignment member for the board 186 together with side walls not illustrated. The heater may now be energised to solder together the contact areas of the board and flexible circuit.

Another embodiment of the invention is intended to overcome a major problem encountered in placing leadless chip carriers on printed circuit boards. Due to different coefficients of thermal expansion and residual strains remaining after soldering a chip carrier to a board, solder joints fail and very expensive integrated circuits and/or boards may be lost. In addition, these devices often have a high failure rate and a connector such as disclosed herein that permits components to be readily removed and replaced is highly desirable. Referring specifically to Figure 12 of the accompanying drawings, there is illustrated a connector structure for relieving such problems.

A ceramic carrier 200 with leads 202 formed thereon, has a chip 204 secured thereto in a conventional manner. The ceramic carrier has in its preferred embodiment as illustrated, a series of vertical, as viewed in Figure 12, castellations or recesses 206 formed therein. Each castellation 206, or other connection, intercepts a different lead 202 or several such leads and is filled with solder, gold or gold alloy for use at brazing temperatures.

Located between the ceramic chip carrier 200 and a printed circuit board, or other appropriate circuit or circuit carrier, is a flexible circuit according to the present invention. The use of the flexible circuit permits the assembly to "move" with stress and temperature changes and thus greatly reduces failures in the solder due to cold working. Specifically, flexible circuit 208 (see also Figure 13) is of the same shape (square, rectangle, etc.) as the leadless chip carrier; a square is illustrated in Figure 13. A heater 210 following a square path but with the sides of the square lying at 45° to the sides of the flexible circuit, lies within the confines of the flexible circuit and intercepts the edges of the latter at their mid points. The flexible circuit has a plurality of conductors 212 which are exposed where these align with the conductors on the board to which the chip is to be connected at terminals 214. The conductors 212 are long enough to extend from terminals 214 lying under the heater, as illustrated in Figure 13, such that when the flexible circuit is folded over to cause the apices of the four triangles 216, 218, 220, 222 to meet at the centre of the square, the conductors extend up around the edge of heater 210 and over the top of the heater into alignment with the castellations 206, as seen in Figure 12. The pattern of conductors illustrated in Figure 13 is not the only pattern that can be employed, being determined by the pattern of conductors on the printed circuit board or other circuit to be contacted by the flexible circuit.

In use, the folded flexible circuit, which has solder or conductive adhesive applied to the exposed flexible circuit conductors, is laid on the printed circuit board, the leadless chip carrier is placed on the flexible circuit and the heater 210 is energised by applying a constant alternating current to terminals 226 of the heater 210. Both sets of contacts are soldered together concurrently, or separately if desired, with the flexible circuit thereby connecting the printed circuit board and the chip carrier. If desired, the flexible circuit may be cut away in the region defined within the confines of the heater so that the carrier 200 can be bonded to the board by epoxy or other suitable bonding agent. In addition to the advantages achieved by the use of the flexible circuit, strength is added to the structure by fillets of solder 228, see Figure 14, formed at the junction of the flexible circuit and the carrier 200, which fillets in conjunction with the circuit traces in the flexible circuit and the solder in the castellations provide a long thin well-supported beam of solder and copper of relatively high strength, thus greatly increasing the ability of the system to tolerate the different coefficients of thermal expansion of the various elements of the system. Conductive adhesive which may be thermally actuated may also be employed in the castellations with perhaps some loss of strength in the beam.

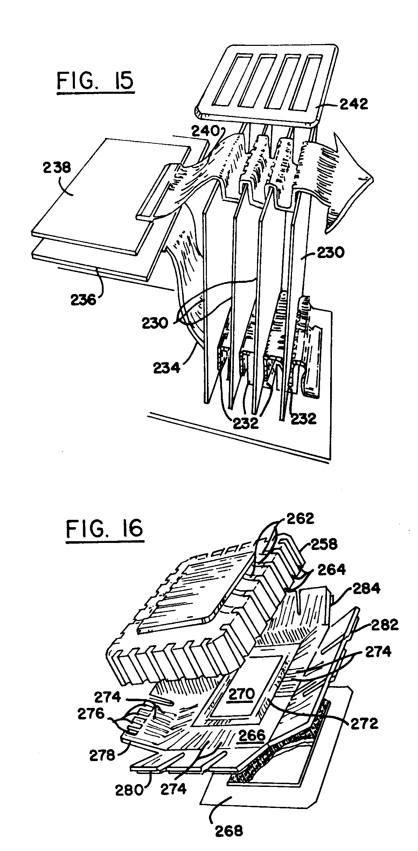

Due to the great flexibility of flexible circuits, an arrangement such as illustrated in Figure 15 is possible. In such a structure a plurality of vertical, as viewed in the Figure, printed circuit boards 230 are held in an upright position by holders 232. A flexible circuit 234 extends from a printed circuit board 236 into each holder 232 passing between the sides and bottom of the holders and the sides and bottom of the boards adjacent a terminal end of each of the boards 230. At their upper ends, the circuit boards 230 are held in proper spaced relationship by a grid-form holder 242 and a second flexible circuit 240 extends from a printed circuit board 238 into contact with the faces of the boards 230 in similar fashion to the flexible circuit 234. Either the holders 232 and 242 or the flexible circuits 234 and 240 may have the heaters formed thereon, depending upon preference. In each location where a connection is to be made the flexible circuit conductor is bared. It should be noted that the term flexible circuit as used herein is not limited to circuits as such but also includes flat cable, multiconductor flexible conductor straps such as are used to connect the movable heads of dot matrix printers to the print control circuits, and the like.

Referring specifically to Figure 16, there is illustrated a modification of the structure of Figure 12. A ceramic chip carrier 258 has a chip attached thereto. Conductors 262 extend from chip contacts to solder filled castellations 264.

A flexible circuit 266 is secured to a printed circuit board 268 and to the chip carrier 258 by a heat activated adhesive. The flexible circuit has a centrally located heater 270 and adhesive is applied to both its upper and lower surfaces as illustrated in Figure 16 so that when the flexible circuit is set on the board 268 and the ceramic is set on the flexible circuit, the heater can be energised whereby the adhesive is activated and the elements become mechanically joined by thermal bonding.

The flexible circuit 266 has a second heater 272 which surrounds the heater 270 and is disposed over the bared and tinned ends, not illustrated, of conductors 274, facing the printed circuit board 268. Upon energisation of the heater 272 the ends of the conductors 274 are soldered to mating conductors on the printed circuit board 268.

The flexible circuit 266 is folded up along the edges of the chip carrier 258 so that tinned ends 276 of conductors 274 are brought into contact with the solder in the castellations 264. A heater is provided behind each group of contacts 276, these being designated by numerals 278, 280, 282 and 284. When energised the heaters cause the ends 276 of conductors 274 to be soldered to the chip carrier so that a circuit for each lead 262 is completed through the solder of castellation 264, conductors 274 and through the terminals under heater 272 to the printed circuit board 268.

The heater has been illustrated in two different forms in Figures 3 and 9. Another version of the heater is illustrated in Figure 17 of the accompanying drawings. A flat copper bar 286, quite long but quite narrow, is coated on one surface with a layer of ferromagnetic material 288. The copper bar is folded in half at 290 through a 180° angle so that the two halves of the bar are parallel to one another. An insulation layer 292 is disposed between the now juxtaposed regions of the ferromagnetic layer 88.

This heater is quite thin and very effective; being of the order of 0.016 inch (0.4mm) thick.

When soldering to very closely spaced leads, as small as .006 inch (0.15mm) between centres, a solder reflow pad may be required. Referring specifically to Figures 18 and 19 of the accompanying drawings, a heater, flexible circuit and reflow pad arrangement is illustrated. The heater consists of buss 294, insulation layer 296, ferromagnetic layer 298 and outer copper layer 300. Flexible circuit 302 is folded around the heater and a solder reflow layer 304 overlies the exposed conductors of the flexible circuit. The solder reflow layer, which is secured to the flexible circuit in the region of the exposed conductors, is an insulating layer with windows 306 filled with solder 308. The spacing between windows corresponds to the spacing between conductors of the flexible circuit. The windows in the reflow layer confine the solder to the metal conductors and prevent short circuiting of the conductors. The reflow layer may alternatively be composed of two layers of insulating material with aligned windows with a continuous strip of solder in between the same. Either arrangement is acceptable. In cases where the surface is not regular a smooth elastomeric layer may be added for compliance and to maintain a relatively constant normal force across the contact area.

Some of the advantages of the flexible circuit of the invention now become readily apparent. The connection arrangement provides an unusually low profile; the contacts are, in effect, self soldering; very fine trace spacing, as little as .006" (.15mm), is currently possible; the heater is fully shielded and there are no long term creep problems, no contact resistance changes and no problems resulting from vibration; these features all being due to the self soldering capability of the flexible circuit. When using spacings of as little as .006" (.15mm), a reflow solder pad, such as illustrated in Figure 18, is preferably employed.

Another interesting advantage of the use of a flexible circuit with heater relates to avoiding corrosion and/or oxidation of the exposed solder and contacts during shipping and storage of the circuits. As a result of the availability of a heat source applying heat uniformly to all solder-conductor regions, the circuit may be bonded to a metallic plate for storage and shipping, thus excluding air and moisture from contact areas. When it is desired to use the circuit, the heater is energised so that the board can be removed from the metallic plate, leaving clean exposed solder surfaces.

Although reference is made throughout to solder as the heat sensitive bonding material, other heat sensitive, conductive, bonding materials may be employed. Such other materials may include conductive thermosetting and thermoplastic resins; and the term "solder" includes liquid solders, and gold and silver solders, all of which may be employed in various of the embodiments.

The term "constant current" as employed herein does not mean a current that cannot increase but means a current that obeys the following formula

$$\frac{dI}{I} > -1/2 \frac{dR}{R} . \qquad (1)$$

Specifically, in order to autoregulate, the power delivered to the load when the heater exceeds Curie temperature must be less than the power delivered to the load below Curie temperature. If the current is held invariable, then the best autoregulating ratio is achieved short of controlling the power supply to reduce current. So long, however, as the current is reduced sufficiently to reduce heating, autoregulation is achieved. Thus when large autoregulating ratios are not required, constraints on the degree of current control may be relaxed thereby reducing the cost of the power supply.

The above equation is derived by analysing the equation:

$$P = (I + \Delta I)^2 (R + \Delta R)$$

where P is power.
Differentiating P with respect to R

$$\frac{dP}{dR} = I^2 + 2RI \left(\frac{dI}{dR}\right)$$

and to satisfy the requirements for autoregulation

$$\frac{dP}{dR} > 0.$$

Thus,

$$I^2 + 2RI \frac{dI}{dR} > 0$$

which reduces to Equation 1 above.

## Claims

1. An electrical circuit assembly for connection to other circuits, comprising one or more electrical conductors embedded in and covered by a body of insulating material having two large opposed surfaces, said conductor or each conductor having a connection region where it is exposed at one of said opposed surfaces, characterised in that the body of insulating material (4) containing the embedded conductor or conductors (6) is flexible and a self-regulating electrical resistance heater (12) to apply heat for making electrical connection, especially soldered connection, and adapted to be energised from a source of substantially constant a.c. current is disposed along the other of said opposed surfaces at the region opposite that where said conductor or conductors are exposed.

2. An assembly according to Claim 1, wherein said exposed surface (10) of said conductor or each conductor is covered with solder.

3. An assembly according to Claim 1 or Claim 2, wherein said body of insulating material is in the form of a flexible board or strap and has a multiplicity of conductors embedded in it a plurality of which are exposed at the connection region in a predetermined array, and the heater is elongated to extend along said array but on the opposite surface of the board or strap.

4. An assembly according to Claim 3, further including a solder carrier pad (35) of insulating material which overlies said array of exposed portions of the conductors and has a series of apertures in alignment with said exposed portions which are filled with solder.

5. An assembly according to Claim 4, wherein the solder carrier pad has a compliant insulating layer generally coextensive with the pad.

6. An assembly according to any of Claims 3 to 5, wherein said body of insulating material has a flap extending beyond the connection region which contains no conductors and is folded back over the heater to cover it.

7. An assembly according to any preceding claim, wherein said heater is of the order of .76 mm thick.

8. An assembly according to any of Claims 3 to 6, further including a second electrical circuit for connection to said flexible circuit board and having a pattern of conductors with an array of exposed portions generally the same as the array of exposed portions of the conductors of the flexible circuit, with means for aligning said two arrays when the circuits are brought together for connection.

9. An assembly according to any of claims 3 to 6, wherein said flexible circuit has a plurality of different connection regions at each of which there is a different array of exposed portions of the conductors along one surface, with a respective heater lying opposite the array along the other surface of the flexible circuit, and further including a respective plurality of other electrical circuits each having electrical conductors with an array of exposed portions generally the same as a respective one of the arrays of exposed portions of the flexible circuit, with means for aligning each of the arrays of exposed conductor portions of the flexible circuit with the array of exposed conductor portions of the respective other circuit when the circuits are assembled together.

10. An assembly according to any of Claims 3 to 6, including an electrical connector for connection to said flexible circuit board and having a plurality of alternating bands of insulating material and conductive material, said bands of conductive material having a spacing and pattern corresponding to said exposed portions of the conductors of the flexible circuit, with means for aligning said bands of conductive material and said exposed conductor portions for connection of respective conductive bands to respective flexible circuit conductors.

11. An assembly according to any of Claims 8 to 10, wherein said aligning means comprises at least one holder having at least one opening within which the flexible circuit is constrained to lie, a separate circuit board also being accommodated in the same opening for contact with the flexible circuit.

12. An assembly according to Claim 11, wherein the holder is generally U-shaped and the flexible circuit is constrained to adopt substantially a U-configuration within the holder, the separate circuit board being inserted between the legs of the U.

13. An assembly according to Claim 11, wherein the holder is generally in the form of an elongated box open at the top and bottom, the flexible circuit is constrained to adopt substantially a U-configuration within the box, the separate circuit board being inserted between the sides of the box, and a further separate circuit board or connector lies across the open bottom of the box in contact with the base of the U.

14. An assembly according to Claim 11, wherein the holder incorporates spring means for spring-pressing the separate circuit board against the flexible circuit.

15. An assembly according to Claim 14, wherein the holder is generally in the form of a spring clip to grip a marginal portion of the separate circuit board, with location means for locating the clip-like holder in correct position on said board.

16. An assembly according to any of Claims 3 to 6, including a separate circuit board and an insulating mount secured thereon and carrying a further electronic component, the flexible circuit being interposed between the mount and the circuit board to connect terminals of the electronic component to conductors on the circuit board.

17. An assembly according to Claim 16, wherein the flexible circuit is folded up to enable conductors of the flexible circuit to reach the terminals of the component on the mount.

18. An assembly according to Claim 16 or Claim 17, wherein the mount has castellations or recesses around its sides containing terminals of the component on the mount and solder.

19. An assembly according to any of Claims 16 to 18, wherein the flexible circuit is provided with a first self-regulating heater or group of such heaters for soldering the electrical connections and a further heater for activating a heat-activatable bonding material to bond the mount and the flexible circuit to the circuit board.

20. An assembly according to any of Claims 16 to 18, wherein the flexible circuit is of square configuration, the self-regulating heater follows a path having the configuration of a smaller square within the confines of the larger square defining the flexible circuit, the smaller square having its sides at 45° with respect to the sides of the larger square, and the four corners of the square flexible circuit are folded in to meet at the centre of the squares.

21. A method of making multiple electrical circuit connections, such as in the connecting together of electrical circuit boards, wherein a first array of exposed portions of otherwise insulated electrical conductors embedded in a circuit board are soldered to a co-operating second array of exposed portions of conductors of another circuit assembly by the application of heat to melt the solder, characterised in that said first array of conductor portions is exposed at one surface of a circuit board made of a flexible insulating material and, after the two arrays of exposed conductor portions have been brought together in assembled alignment and solder has been supplied to their contact surfaces, the heat to melt the solder is generated by a self-regulating electrical resistance heater energised by a substantially constant a.c. current which heater is applied to the other surface of the flexible circuit board opposite to said first array of exposed conductor portions.

22. The method according to Claim 21, wherein prior to assembly of said two arrays of exposed conductor portions, the conductor portions of the flexible circuit board are protected by a cover plate soldered thereto which cover plate is released for removal to expose said conductor portions in readiness for assembly by energising said heater to fuse the solder.

**Patentansprüche**

1. Elektrische Schaltungsanordnung zur Verbindung mit anderen Schaltungen, mit einem oder mehreren elektrischen Leitern, die eingebettet sind in einem oder bedeckt von einem Körper aus isolierendem Material mit zwei großen, gegenüberliegenden Flächen, wobei der oder jeder Leiter einen Verbindungsbereich aufweist, wo er auf einer der gegenüberliegenden Flächen freiliegt, **dadurch gekennzeichnet, daß** der Körper aus isolierendem Material (4), der den oder die eingebetteten Leiter (6) aufweist, flexibel ist, und daß ein selbstregulierender elektrischer Widerstandsheizer (12), der zur Zuführung von Wärme zur Herstellung elektrischer Verbindung, insbesondere Lötverbindung, dient und der zur Speisung von einer Quelle im wesentlichen konstanten Wechselstromes geeignet ist, entlang der anderen der gegenüberliegenden Flächen in dem Bereich angeordnet ist, der von dem abgewandt ist, wo der genannte Leiter oder die Leiter freiliegen.

2. Anordnung nach Anspruch 1, **dadurch gekennzeichnet, daß** die genannte freiliegende Oberfläche (10) des genannten Leiters oder jedes Leiters mit Lot bedeckt ist.

3. Anordnung nach Anspruch 1 oder 2, **dadurch gekennzeichnet, daß** der genannte Körper aus isolierenden Material die Form einer flexiblen Karte oder eines Streifens hat und in sich eine Anzahl von darin eingebetteten Leitern aufweist, von denen eine Anzahl in dem Verbindungsbereich in einer vorbestimmten Anordnung freiliegen, und daß der Heizer langgestreckt ist und sich entlang der genannten Anordnung, jedoch auf der gegenüberliegenden Oberfläche der Karte oder des Streifens erstreckt.

4. Anordnung nach Anspruch 3, gekennzeichnet durch eine Lotträgerkonsole (35) aus isolierendem Material, die sich über die genannte Anordnung freiliegender Abschnitte der Leiter erstreckt und eine Reihe von Ausnehmungen aufweist, die mit den genannten freiliegenden Abschnitten fluchten und mit Lot gefüllt sind.

5. Anordnung nach Anspruch 4, **dadurch gekennzeichnet, daß** die Lotträgerkonsole eine polsternde isolierende Schicht im wesentlichen über die Konsole aufweist.

6. Anordnung nach einem der Ansprüche 3 bis 5, **dadurch gekennzeichnet, daß** der Körper aus isolierendem Material eine Lasche aufweist, die sich über den Verbindungsbereich hinaus erstreckt und keine Leiter aufweist und über den Heizer hinweg zurückgefaltet ist, um ihn zu bedecken.

7. Anordnung nach einem der vorhergehenden Ansprüche, **dadurch gekennzeichnet, daß** der Heizer in der Größenordnung von 0,76 mm dick ist.

8. Anordnung nach einem der Ansprüche 3 bis 6, gekennzeichnet durch eine zweite elektrische Schaltung zur Verbindung mit der genannten flexiblen Leiterplatte und mit einem Muster von Leitern mit einer Anordnung von freiliegenden Abschnitten im wesentlichen in der gleichen Weise wie die Anordnung von freiliegenden Abschnitten der Leiter der flexiblen Schaltung, mit Mitteln zur Ausrichtung der genannten beiden Anordnungen, wenn die Schaltungen zum Zwecke der Verbindung zusammengebracht sind.

9. Anordnung nach einem der Ansprüche 3 bis 6, **dadurch gekennzeichnet, daß** die flexible Schaltung eine Anzahl von unterschiedlichen Verbindungsbereichen aufweist, in denen sich jeweils eine unterschiedliche Anordnung von freiliegenden Abschnitten der Leiter entlang einer Oberfläche befindet, wobei jeweils ein Heizer gegenüber der Anordnung entlang der anderen Oberfläche der flexiblen Schaltung liegt, und daß die flexible Schaltung weiterhin eine jeweilige Anzahl von anderen elektrischen Schaltungen aufweist, die jeweils elektrische Leiter mit einer Anordnung von freiliegenden Abschnitten im wesentlichen in den gleichen Weise wie eine der jeweiligen Anordnungen der freiliegenden Abschnitte der flexiblen Schaltung aufweist, mit Mitteln zur Ausrichtung jeder der Anordnungen freiliegender Leiterabschnitte der flexiblen Schaltung mit der Anordnung von freiliegenden Leiterabschnitten der jeweiligen anderen Schaltung, wenn die Schaltungen zusammengefügt sind.

10. Anordnung nach einem der Ansprüche 3 bis 6, gekennzeichnet durch einen elektrischen Leiter zum Ausschluß der flexiblen Schaltungsplatte und mit einer Anzahl von wechselnden Bändern von isolierendem Material und leitendem Material, wobei die genannten Bänder leitenden Materials einen Abstand und ein Muster entsprechend den freiliegenden Abschnitten der Leiter der flexiblen Schaltung aufweisen, mit Mitteln zur Ausrichtung der genannten Bänder von leitendem Material und der genannten freiliegenden Leiterabschnitte zur Verbindung von jeweiligen leitenden Bändern mit jeweiligen flexiblen Schaltungsleitern.

11. Anordnung nach einem der Ansprüche 8 bis 10, **dadurch gekennzeichnet, daß** die genannten Ausrichtmittel wenigstens einen Halter mit wenigstens einer Öffnung darin aufweisen, innerhalb der die flexible Schaltung gefangen ist, wobei eine getrennte Leiterplatte ebenfalls in der gleichen Öffnung zum Kontakt mit der flexiblen Schaltung aufgenommen ist.

12. Anordnung nach Anspruch 11, **dadurch gekennzeichnet, daß** der Halter im wesentlichen U-förmig ist und die flexible Schaltung derart gefangen ist, daß sie im wesentlichen eine U-Form innerhalb des Halters annimmt, wobei die getrennte Leiterplatte zwischen den Schenkeln des U eingesetzt ist.

13. Anordnung nach Anspruch 11, **dadurch gekennzeichnet, daß** der Halter im wesentlichen die Form eines langgestreckten Kastens hat, der oben und unten offen ist, wobei die flexible Schaltung so gefangen ist, daß sie im wesentlichen eine U-Form innerhalb des Kastens annimmt, wobei die getrennte Leiterplatte zwischen den beiden Seiten des Kastens eingesetzt ist und wobei eine weitere getrennte Leiterplatte oder ein Verbinder quer über den offenen Boden des Kastens in Kontakt mit der Basis des U liegt.

14. Anordnung nach Anspruch 11, **dadurch gekennzeichnet, daß** der Halter Federmittel aufweist, die federnd die getrennte Leiterplatte gegen die flexible Schaltung drückt.

15. Anordnung nach Anspruch 14, **dadurch gekennzeichnet, daß** der Halter im wesentlichen die Form einer Federklammer hat, um einen Randbereich der getrennten Leiterplatte zu ergreifen, mit Paßmitteln zur Festlegung des klammerartigen Halters in richtiger Position auf der Platte.

16. Anordnung nach einem der Ansprüche 3 bis 6, gekennzeichnet durch eine getrennte Leiterplatte und eine isolierende Halterung, die darauf befestigt ist und ein weiteres elektronisches Bauteil hält, wobei die flexible Schaltung zwischen der Halterung und der Leiterplatte angeordnet ist, um die Anschlüsse des elektronischen Bauteils mit den Leitern auf der Leiterplatte zu verbinden.

17. Anordnung nach Anspruch 16, **dadurch gekennzeichnet, daß** die flexible Schaltung aufgefaltet ist, so daß Leiter der flexiblen Schaltung in der Lage sind, die Anschlüsse des Bauteils auf der Halterung zu erreichen.

18. Anordnung nach Anspruch 16 oder 17, **dadurch gekennzeichnet, daß** die Halterung Zacken oder Ausnehmungen rund um seine Seiten zur Aufnahme von Anschlüssen des Bauteils auf der Halterung und Lot aufweist.

19. Anordnung nach einem der Ansprüche 16 bis 18, **dadurch gekennzeichnet, daß** die flexible Schaltung einen ersten selbstregulierenden Heizer oder eine Gruppe von solchen Heizern zum Löten der elektrischen Verbindungen und einen weiteren Heizer zur Aktivierung eines wärmeaktivierbaren Bindemittels aufweist, um die Halterung und die flexible Schaltung mit der Leiterplatte zu verbinden.

20. Anordnung nach einem der Ansprüche 16 bis 18, **dadurch gekennzeichnet, daß** die flexible Schaltung quadratisch ist, daß der selbstregulierende Heizer einem Pfad in Form eines kleineren Quadrates innerhalb der Grenzen des größeren, die flexible Schaltung definierenden Quadrats folgt, wobei die Seiten des kleineren Quadrates 45° zu den Seiten des größeren Quadrats liegen und die 4 Ecken der quadratischen flexiblen Schaltung nach innen gefaltet sind und sich im Zentrum der Quadrate treffen.

21. Verfahren zur Herstellung mehrerer elektrischer Schaltungsverbindungen, beispielsweise bei der Verbindung von elektrischen Leiterplatten, wobei eine erste Anordnung von freiliegenden, im übrigen isolierten, in einer Leiterplatte eingebetteten Abschnitten von Leitern mit einer wirkungsverbundenen zweiten Anordnung von freiliegenden Abschnitten von Leitern einer anderen Schaltungsanordnung durch Zuführung von Wärme zum Zwecke des Schmelzens des Lotes verlötet werden, **dadurch gekennzeichnet, daß** die erste Anordnung von Leiterabschnitten einer Oberfläche einer Leiterplatte aus flexiblem, isolierendem Material freigelegt wird und daß, nachdem die beiden Anordnungen von freigelegten Leiterabschnitten in zusammengefügter Ausrichtung zusammengebracht sind und Lot an ihre Kontaktoberflächen gebracht worden ist, die Wärme zum Schmelzen des Lotes durch einen selbstregulierenden elektrischen Widerstandsheizer erzeugt wird, der im wesentlichen mit einem konstanten Wechselstrom gespeist ist und der an die andere Oberfläche der flexiblen Leiterplatte gebracht wird, die der zuerst genannten Anordnung von freiliegenden Leiterabschnitten abgewandt ist.

22. Verfahren nach Anspruch 21, **dadurch gekennzeichnet, daß** vor dem Zusammenfügen der beiden Anordnungen von freiliegenden Leiterabschnitten die Leiterabschnitte der flexiblen Schaltungsplatte durch eine Deckplatte geschützt werden, die daran angelötet ist und die zur Entfernung freigegeben wird, um die genannten Leiterabschnitte in Bereitschaft für den Zusammenbau durch Speisung des Heizers zum Schmelzen des Lotes freizulegen.

**Revendications**

1. Ensemble de circuit électrique destiné à être connecté à d'autres circuits, comprenant un ou plusieurs conducteurs électriques noyés dans, et recouverts par un corps en matériau isolant présentant deux grandes surfaces opposées, ledit conducteur ou chaque conducteur présentant une zone de connexion exposée à l'une desdites surfaces opposées, caractérisé en ce que le corps en matériau isolant (4) contenant le ou les conducteurs noyés (6) est flexible, et un élément de chauffage à résistance électrique autoréglable (12), servant à appliquer de la chaleur pour produire une connexion électrique, spécialement une connexion soudée, et adapté pour être activé par une source de courant alternatif sensiblement constante, est disposé le long de l'autre desdites surfaces opposées, sur la zone opposée à la zone d'exposition du ou desdits conducteurs.

2. Ensemble selon la revendication 1, dans lequel ladite surface exposée (10) dudit conducteur ou de chaque conducteur est recouverte avec de la soudure.

3. Ensemble selon la revendication 1 ou 2, dans lequel ledit corps en matériau isolant se présente sous la forme d'un circuit ou connexion souples et présente une pluralité de conducteurs noyés en lui, dont une pluralité est exposée au niveau de la zone de connexion pour produire une matrice prédéterminée, et l'élément de chauffage est allongé pour s'étendre le long de ladite matrice, mais sur la surface opposée du circuit ou connexion.

4. Ensemble selon la revendication 3, comprenant en outre une pastille porteuse de soudure (35) en matériau isolant, qui recouvre ladite matrice de parties exposées des conducteurs et présente une série d'ouvertures alignées avec lesdites parties exposées, qui sont remplies avec de la soudure.

5. Ensemble selon la revendication 4, dans lequel la pastille porteuse de soudure présente une couche isolante déformable, s'étendant généralement conjointement avec la pastille.

6. Ensemble selon l'une quelconque des revendications 3 à 5, dans lequel ledit corps en matériau isolant présente un volet s'étendant au-delà de la zone de connexion, qui ne contient pas de conducteurs et est replié sur l'élément de chauffage pour le recouvrir.

7. Ensemble selon l'une quelconque des revendications précédentes, dans lequel ledit élément de chauffage présente une épaisseur de l'ordre de 0,76 mm.

8. Ensemble selon l'une quelconque des revendications 3 à 6, comprenant en outre un second circuit électrique destiné à être connecté à ladite carte imprimée souple et présentant un motif de conducteurs dotés d'une matrice de parties exposées, généralement la même que la matrice de parties exposées des conducteurs du circuit souple, et un moyen pour aligner lesdites deux matrices lorsque les circuits sont rapprochés l'un vers l'autre pour être connectés.

9. Ensemble selon l'une quelconque des revendications 3 à 6, dans lequel ledit circuit souple présente une pluralité de zones de connexion différentes sur chacune desquelles il existe une matrice différente de parties exposées des conducteurs le long d'une surface, et un élément de chauffage respectif se situant à l'opposé de la matrice, le long de l'autre surface du circuit souple, et comprenant en outre une pluralité correspondante d'autres circuits électriques présentant chacun des conducteurs électriques dotés d'une matrice de parties exposées, généralement la même que celles correspondantes des matrices de parties exposées du circuit souple, et un moyen pour aligner chacune des matrices de parties de conducteur exposées du circuit souple avec la matrice de parties de conducteur exposées de l'autre circuit respectif, lorsque les circuits sont assemblés l'un à l'autre.

10. Ensemble selon l'une quelconque des revendications 3 à 6, comprenant un connecteur électrique destiné à être connecté à ladite carte imprimée souple et présentant une pluralité de bandes alternées réalisées en matériau isolant et en matériau conducteur, lesdites bandes de matériau conducteur présentant un espacement et un motif correspondant auxdites parties exposées des conducteurs du circuit souple, et un moyen pour aligner lesdites bandes de matériau conducteur et lesdites parties de conducteur exposées, pour permettre la connexion des bandes conductrices respectives aux conducteurs de circuit souple correspondants.

11. Ensemble selon l'une quelconque des revendications 8 à 10, dans lequel ledit moyen d'alignement comprend au moins un organe de support présentant au moins une ouverture dans laquelle le circuit flexible est maintenu de force, une carte imprimée séparée étant également logée dans la même ouverture pour venir en contact avec le circuit souple.

12. Ensemble selon la revendication 11 dans lequel l'organe de support a une forme générale en U et le circuit souple est forcé d'adopter une forme générale en U dans l'organe de support, la carte imprimée séparée étant introduite entre les branches du U.

13. Ensemble selon la revendication 11, dans lequel l'organe de support se présente généralement sous la forme d'un boîtier allongé, ouvert en partie haute et en partie basse, le circuit souple est forcé à adopter une configuration sensiblement en forme de U à l'intérieur du boîtier, le circuit souple séparé étant inséré entre les côtés du boîtier, et une autre carte imprimée séparée ou connecteur se situe sur le fond ouvert du boîtier, en contact avec la base de la forme en U.

14. Ensemble selon la revendication 11, dans lequel le support incorpore un moyen élastique pour comprimer élastiquement la carte imprimée séparée contre le circuit souple.

15. Ensemble selon la revendication 14, dans lequel le support se présente généralement sous la forme d'une pince à ressort pour saisir une partie marginale de la carte imprimée séparée, un moyen de positionnement servant à positionner le support en forme de pince dans une position correcte sur ladite carte.

16. Ensemble selon l'une quelconque des revendications 3 à 6, comprenant une carte imprimée séparée et une monture isolante, et supportant un autre composant électronique, le circuit souple étant interposé entre la monture et la carte imprimée pour connecter les bornes du composant électronique à des conducteurs situés sur la carte imprimée.

17. Ensemble selon la revendication 16, dans lequel le circuit souple est plié pour permettre aux conducteurs du circuit souple d'atteindre les bornes du composant situé sur la monture.

18. Ensemble selon la revendication 16 ou 17, dans lequel la monture présente des crénelures ou cavités autour de ses côtés, contenant les bornes du composant situé sur la monture et de la soudure.

19. Ensemble selon l'une quelconque des revendications 16 à 18, dans lequel le circuit souple est pourvu d'un premier élément de chauffage autoréglable ou d'un groupe de tels éléments de chauffage, pour permettre le soudage des connexions électriques, et un autre élément de chauffage pour activer un matériau de liaison susceptible d'être activé par la chaleur, pour lier la monture et le circuit souple à la carte imprimée.

20. Ensemble selon l'une quelconque des revendications 16 à 18, dans lequel le circuit souple présente une configuration carrée, l'élément de chauffage auto-réglable suit une trajectoire ayant la configuration d'un carré plus petit, dans les limites du carré plus grand qui définit le circuit souple, le carré plus petit présentant ses côtés formant un angle de 45° par rapport aux côtés du carré plus grand, et les quatre angles du circuit souple carré sont pliés vers l'intérieur pour se rejoindre au centre des carrés.

21. Procédé de réalisation de connexions de circuit électrique multiples, comme dans la connexion de cartes imprimées électriques entre elles, dans lequel une première matrice de parties exposées de conducteurs électriques autrement isolés, noyés dans une carte imprimée, est soudée à une seconde matrice coopérante de parties exposées de conducteurs d'un autre ensemble de circuit, grâce à l'application de chaleur pour faire fondre la soudure, caractérisé en ce que ladite première matrice de parties de conducteur est exposée au niveau d'une surface d'une carte imprimée réalisée en matériau isolant souple et, après que les deux matrices de parties de conducteur exposées aient été placées en alignement assemblé et que de la soudure ait été appliquée sur leurs surfaces de contact, la chaleur servant à faire fondre la soudure est produite par un élément de chauffage à résistance électrique autoréglable activé par un courant alternatif pratiquement constant, cet élément de chauffage étant appliqué sur l'autre surface de la carte imprimée souple opposée à ladite première matrice de parties de conducteur exposées.

22. Procédé selon la revendication 21, dans lequel, avant d'assembler lesdites deux matrices de parties de conducteur exposées, les parties de conducteur de la carte imprimée souple sont protégées par une plaque de recouvrement soudée à cette dernière, cette plaque de recouvrement étant retirée pour permettre l'exposition desdites parties de conducteur de manière à être prêtes à l'assemblage, réalisé grâce à l'activation dudit élément de chauffage pour faire fondre la soudure.

FIG. 1

FIG. 2

FIG. 1A

FIG. 3

FIG. 4

FIG. 5

FIG. 5A

FIG. 6

FIG. 8

FIG. 7

## FIG. 9

## FIG. 10

## FIG. 11

FIG. 12

FIG. 13

FIG. 14

FIG. 15

FIG. 16

FIG. 17

290
286
292
288

FIG. 19

304
306
308
294
296
300
298

FIG. 18

294
298
300
302
304
304
306
306
302
308
294
298
296
300
304